# EUROPEAN PATENT SPECIFICATION

(11) **EP 4 440 257 B1**
(45) Date of publication and mention of the grant of the patent: **08.07.2026**
(21) Application number: 22925098.0
(22) Date of filing: 28.11.2022
(51) Int. Cl.: H04B 1/3816, H04M 1/02, H04M 1/18, H05K 5/00, H05K 5/06

(54) **ELECTRONIC DEVICE HAVING WATERPROOF STRUCTURE**
ELEKTRONISCHE VORRICHTUNG MIT WASSERDICHTER STRUKTUR
DISPOSITIF ÉLECTRONIQUE COMPRENANT UNE STRUCTURE ÉTANCHE À L'EAU

(30) Priority: 04.02.2022 KR 20220014986; 14.02.2022 KR 20220019027
(43) Date of publication of application: 02.10.2024
(73) Proprietor: Samsung Electronics Co., Ltd., Suwon-si, Gyeonggi-do 16677 (KR)
(72) Inventor: YANG, Yonghee, Suwon-si Gyeonggi-do 16677 (KR); KIM, Sanguk, Suwon-si Gyeonggi-do 16677 (KR); NA, Hyoseok, Suwon-si Gyeonggi-do 16677 (KR); LEE, Minsoo, Suwon-si Gyeonggi-do 16677 (KR); KU, Doil, Suwon-si Gyeonggi-do 16677 (KR); RYU, Jangyoung, Suwon-si Gyeonggi-do 16677 (KR); JUN, Jaeyoung, Suwon-si Gyeonggi-do 16677 (KR); JU, Wanjae, Suwon-si Gyeonggi-do 16677 (KR)
(74) Representative: HGF
(86) International application number: PCT/KR2022/018965
(87) International publication number: WO 2023/149631

(56) References cited:
- KR-A- 20160 016 625
- KR-A- 20160 142 186
- KR-A- 20180 100 908
- KR-A- 20200 017 446
- US-A1- 2021 042 478

## Description

### [Technical Field]

Various embodiments of the disclosure relate to an electronic device, for example, an electronic device including a waterproof structure.

### [Background Art]

An electronic device may refer to a device that executes a specific function according to a loaded program, such as a home appliance, an electronic notebook, a portable multimedia player, a mobile communication terminal, a tablet PC, a video/audio device, a desktop/laptop computer, or a vehicle navigation device. For example, these electronic devices may output stored information as sound or an image. As the integration level of electronic devices increases and high-speed, large-capacity wireless communication becomes more common, recent single electronic devices such as a mobile communication terminals, may be equipped with various functions. For example, an entertainment function such as games, a multimedia function such as music/video playback, a communication and security function for mobile banking, and a function such as schedule management or an electronic wallet in addition to a communication function are integrated into a single electronic device.

As the use of electronic devices such as mobile communication terminals and smartphones becomes more commonplace, the electronic devices may be exposed to a variety of use environments. For example, in an environment with a large indoor/outdoor temperature difference, an electronic device may be exposed to rapid temperature changes caused by movement of a user, and exposure to high humidity or moisture may cause malfunction or failure of the electronic device. As a way of suppressing the effects of this use environment, the electronic device may be equipped with a waterproof structure. For example, the electronic device may be provided with the waterproof structure to prevent moisture from contaminating the interior of the electronic device.

The above information is presented as background information only to assist with an understanding of the disclosure. No determination has been made, and no assertion is made, as to whether any of the above might be applicable as prior art with regard to the disclosure.

KR 2020 0017446 A discusses a portable electronic device which comprises: a housing which contains a first opening formed to penetrate a side wall and a second opening placed to be adjacent to the first opening and formed to penetrate the side wall; a tray structure which couples to be able to detachably attach to the housing through the first opening and contains tray holes formed to be aligned to be corresponding to the second opening; and a sealing member of which at least part is placed inside the second opening.

### [Detailed Description of the Invention]

### [Technical Problem]

Along with the trend of small and lightweight electronic devices, the integration level of internal electronic components may increase, and mechanical or electrical connection components such as various connectors or sockets may be miniaturized. A connector hole, a connection hole, or an operation hole corresponding to a connection component (e.g., a connector or a socket) may be provided on the exterior of the electronic device. The term 'operation hole' may be understood, for example, as a hole used to apply an external force to separate a storage medium mounted in a socket. This operation hole may be disposed adjacent to a connection hole for disposing the storage medium into the socket therethrough. For example, as connection component(s) such as a socket become smaller, different holes corresponding to one connection component (and/or a storage medium separation structure) may be disposed adjacent to each other.

In applying a waterproof structure to a miniaturized or lightweight electronic device, it may be difficult to dispose an operation hole adjacent to a connection hole. For example, a sufficient gap between the operation hole and the connection hole may be secured, taking into account an elastic force applied to an inner wall of the operation hole or an inner wall of the connection hole by a waterproof member. However, when a sufficient gap between the operation hole and the connection hole is secured in a structure in which a socket and a storage medium separation structure are disposed adjacent to each other due to the miniaturization of connection components, it may be difficult to align the operation hole for applying an external force with the storage medium separation structure. This may lower the stability of an operation of separating a storage medium in the electronic device to which the waterproof structure is applied. When a sufficient gap between the operation hole and the connection hole is secured to apply the waterproof structure, the stability of the storage medium separation operation may be ensured by also securing an appropriate gap between the socket and the storage medium separation structure. However, miniaturized connection components may not be standardized, thereby increasing manufacturing cost or part management cost.

Various embodiments of the disclosure are to address at least the above-mentioned problems and/or disadvantages and to provide at least the advantages described below. Accordingly, various embodiments of the disclosure may provide an electronic device which includes a waterproof structure and allows for a stable storage medium separation operation.

Various embodiments of the disclosure may provide an electronic device including a waterproof structure, which may suppress an increase in manufacturing cost by increasing the standardization rate of components.

Additional aspects according to various embodiments will be set forth in the following detailed description, and will be apparent in part from the description or may be understood through an embodiment of a presented implementation.

### [Technical Solution]

According to an embodiment of the disclosure, and as defined by independent claim 1, an electronic device includes a housing including a first through hole formed to penetrate a side surface and a second through hole disposed adjacent to the first through hole and formed to penetrate the side surface, a protrusion disposed inside the housing to at least partially face the second through hole, a socket disposed inside the housing and aligned with the first through hole, a push bar disposed on one side of the socket to be linearly reciprocable and at least partially aligned with the second through hole, and a waterproof pin sealing the second through hole by being accommodated in the second through hole, and configured to move the push bar by linearly reciprocating within the second through hole by an external force. The waterproof pin is configured to, when reaching a specified position on the second through hole, contact the push bar in a first region of a surface of one end of the waterproof pin, and contact the protrusion in a second region of the surface of the one end of the waterproof pin, the second region is different from the first region.

According to an embodiment of the disclosure, an electronic device includes a housing including a first through hole formed to penetrate a side surface and a second through hole disposed adjacent to the first through hole and formed to penetrate the side surface, a protrusion disposed inside the housing to at least partially face the second through hole, a socket disposed inside the housing and aligned with the first through hole, a push bar disposed on one side of the socket to be linearly reciprocable and at least partially aligned with the second through hole, and a waterproof pin accommodated in the second through hole to be linearly reciprocable and configured to move the push bar based on an external force. The waterproof pin includes a pin member extending along a direction of a linearly reciprocating movement within the second through hole, and at least one first waterproof ring protruding from an outer peripheral surface of the pin member and configured to seal a space or a gap between the outer peripheral surface of the pin member and an inner wall of the second through hole. When the waterproof pin reaches a specified position on the second through hole, a portion of the waterproof pin contacts the protrusion, and the first waterproof ring is at least partially located within the second through hole.

Further advantageous features are defined by the dependent claims.

### [Advantageous Effects]

According to an embodiment of the disclosure, as a waterproof pin that functions as a waterproof member while transmitting an external force to a storage medium separation structure is appropriately aligned with the storage medium separation structure, a stable separation operation may be provided. In an embodiment, a protrusion of a housing may inhibit or prevent an elastic member (e.g., a waterproof ring) forming the waterproof structure from leaving a hole (e.g., an operation hole) of the housing by limiting the range of movement of the waterproof pin, thereby preventing damage to the elastic member in a return operation. In another embodiment, the waterproof pin or the protrusion may stabilize the storage medium separation operation while maintaining appropriate waterproof performance, and thus create an environment in which miniaturized connection components may be standardized. For example, an electronic device according to various embodiments may include a waterproof structure while suppressing an increase in manufacturing cost. Various other effects that may be directly or indirectly identified through the specification may be provided.

### [Brief Description of Drawings]

The above and other aspects, configurations, and/or advantages of various embodiments of the disclosure will be more apparent from the following description taken in conjunction with the accompanying drawings.
FIG. 1 is a block diagram illustrating an electronic device in a network environment according to various embodiments of the disclosure.
FIG. 2 is a perspective view illustrating a front surface of an electronic device according to various embodiments of the disclosure.
FIG. 3 is a perspective view illustrating a rear surface of the electronic device illustrated in FIG. 2.
FIG. 4 is a perspective exploded view illustrating the electronic device illustrated in FIG. 2.
FIG. 5 is a perspective exploded view illustrating a portion of an electronic device according to various embodiments of the disclosure.
FIG. 6 is a plan view illustrating arrangement of a socket in an electronic device according to various embodiments of the disclosure.
FIG. 7 is a perspective view illustrating a protrusion of an electronic device according to various embodiments of the disclosure.
FIG. 8 is a bottom view illustrating a socket and/or a storage medium separation structure in an electronic device according to various embodiments of the disclosure.
FIG. 9 is a perspective view illustrating a waterproof pin in an electronic device according to various embodiments of the disclosure.
FIG. 10 is a front view illustrating a waterproof pin in an electronic device according to various embodiments of the disclosure.
FIG. 11 is a configuration diagram illustrating a state before an external force is applied to a waterproof pin or a storage medium separation structure in an electronic device according to various embodiments of the disclosure.
FIG. 12 is a configuration diagram illustrating a state after an external force is applied to a waterproof pin or a storage medium separation structure in an electronic device according to various embodiments of the disclosure.
FIG. 13 is an enlarged view illustrating a portion 'B' of FIG. 12.
FIG. 14 is a diagram illustrating arrangement of a storage medium separation structure in an electronic device according to various embodiments of the disclosure.

Throughout the accompanying drawings, like reference numerals may be assigned to like parts, components, and/or structures.

### [Mode for Carrying out the Invention]

The following description in conjunction with the accompanying drawings may provide an understanding of various exemplary implementations of the disclosure including the claims and their corresponding content. Although an exemplary embodiment disclosed in the following description includes various specific details to aid understanding, this is considered to be one of various exemplary embodiments. Therefore, it is obvious to those skilled in the art that various changes and modifications may be made to various implementations of the disclosure without departing from the scope of the disclosure. Additionally, for clarity and conciseness, a description of well-known functions and configurations may be avoided.

The terms and words used in the following description and claims may be used to clearly and consistently describe various embodiments of the disclosure, not limited to referential meanings. Accordingly, it will be obvious to those skilled in the art that the following description of various implementations of the disclosure is provided for illustrative purposes, not for the purpose of limiting the disclosure defined by the claims.

Unless the context clearly dictates otherwise, the singular forms "a", "an", and "the" should be understood to include plural meanings. Therefore, for example, a "surface of a component" may be understood to include one or more of the surfaces of the component.

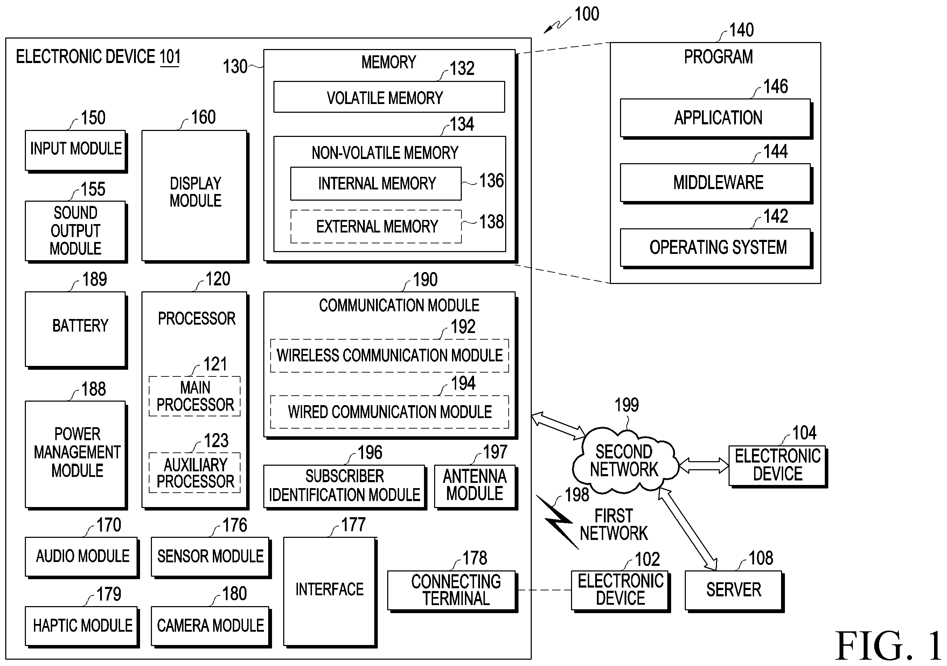

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the strength of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form an mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases. As used herein, such terms as "1^{st}" and "2^{nd}", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, logic, logic block, part, or circuitry. A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., a program) including one or more instructions that are stored in a storage medium (e.g., internal memory or external memory) that is readable by a machine (e.g., an electronic device). For example, a processor (e.g., a processor) of the machine (e.g., the electronic device) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

In the following detailed description, a length direction, a width direction, and/or a thickness direction of an electronic device may be referred to. The length direction may be defined as a 'Y-axis direction', the width direction may be defined as an 'X-axis direction', and/or the thickness direction may be defined as a 'Z-axis direction'. In a certain embodiment, regarding a direction that a component faces, a 'negative sign/positive sign (-/+)' may be referred to together with the Cartesian coordinate system illustrated in the drawings. For example, a front surface of an electronic device or a housing may be defined as a 'surface facing a +Z direction', and a rear surface thereof may be defined as a 'surface facing a -Z direction'. In a certain embodiment, a side surface of the electronic device or the housing may include an area facing a +X direction, an area facing a +Y direction, an area facing a -X direction, and/or an area facing a -Y direction. In another embodiment, the 'X-axis direction' may mean both the '-X direction' and the '+X direction'. This is based on the Cartesian coordinate system depicted in the drawings, for simplicity of description, and it is to be noted that the description of these directions or components does not limit various embodiments of the disclosure.

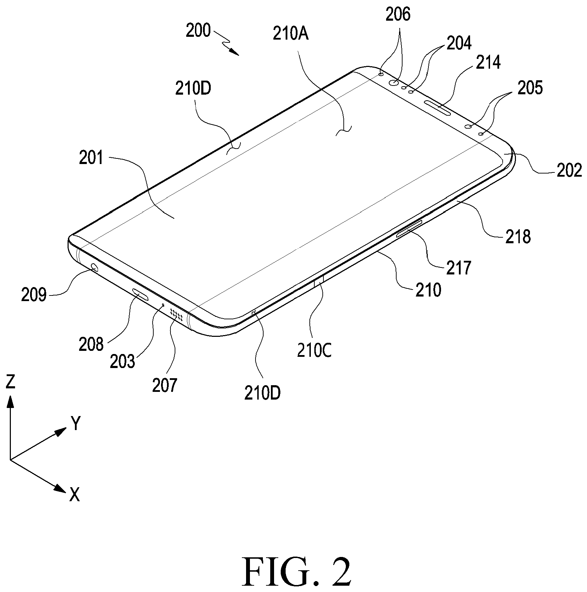

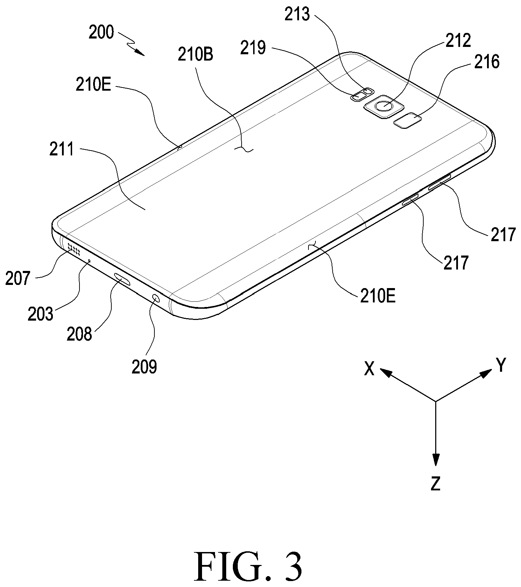

FIG. 2 is a perspective view illustrating a front surface of an electronic device 200 according to various embodiments of the disclosure. FIG. 3 is a perspective view illustrating a rear surface of the electronic device 200 illustrated in FIG. 2.

Referring to FIGS. 2 and 3, the electronic device 200 according to an embodiment may include a housing 210 which includes a first surface (or front surface) 210A, a second surface (or rear surface) 210B, and side surfaces 210C surrounding a space between the first surface 210A and the second surface 210B. In another embodiment (not shown), the housing may refer to a structure that forms a portion of the first surface 210A, the second surface 210B, and the side surfaces 210C. According to an embodiment, at least a portion of the first surface 210A may be formed by a front plate 202 (e.g., a glass plate or polymer plate including various coating layers) which is at least partially substantially transparent. The second surface 210B may be formed by a rear plate 211 which is substantially opaque. The rear plate 211 may be formed of, for example, coated or tinted glass, ceramic, a polymer, a metal (e.g., aluminum, stainless steel (STS), or magnesium), or a combination of at least two of these materials. The side surfaces 220C may be coupled to the front plate 202 and the rear plate 211 and formed by a side structure (or "side bezel structure") 218 including a metal and/or a polymer. In a certain embodiment, the rear plate 211 and the side structure 218 may be integrally formed and include the same material (e.g., a metallic material such as aluminum).

In the illustrated embodiment, the front plate 202 may include two first regions 210D bent and extending seamlessly from the first surface 210A toward the rear plate 211 at both long edges of the front plate 202. In the illustrated embodiment (see FIG. 3), the rear plate 211 may include two second regions 210E bent and extending seamlessly from the second surface 210B toward the front plate 202 at both long edges thereof. In a certain embodiment, the front plate 202 (or the rear plate 211) may include only one of the first regions 210D (or the second regions 210E). In another embodiment, some of the first regions 210D or the second regions 210E may not be included. In these embodiments, when viewed from the sides of the electronic device 200, the side structure 218 may have a first thickness (or width) on side surfaces without the first regions 210D or the second regions 210E, and a second thickness smaller than the first thickness (or width) on side surfaces with the first regions 210D or the second regions 210E.

According to an embodiment, the electronic device 200 may include at least one of a display 201, audio modules 203, 207, and 214, sensor modules 204, 216, and 219, camera modules 205, 212, and 213, key input devices 217, a light emitting element 206, or connector holes 208 and 209. In a certain embodiment, the electronic device 200 may not be provided with at least one (e.g., the key input devices 217 or the light emitting element 206) of the components or additionally include other components.

The display 201 may be visually exposed, for example, through a substantial portion of the front plate 202. In a certain embodiment, at least a portion of the display 201 may be exposed through the front plate 202 forming the first surface 210A or the first regions 210D of the side surfaces 210C. In a certain embodiment, corners of the display 201 may be formed substantially in the same shapes as those of adjacent peripheral portions of the front plate 202. In another embodiment (not shown), a gap between the periphery of the display 201 and the periphery of the front plate 202 may be substantially equal to increase the visually exposed area of the display 201.

In another embodiment (not shown), a recess or an opening may be formed in a portion of a screen display area of the display 201, and at least one of the audio module 214, the sensor module 204, the camera module 205, or the light emitting element 206, which is aligned with the recess or the opening, may be included. In another embodiment (not shown), at least one of the audio module 214, the sensor module 204, the camera module 205, a fingerprint sensor 216, or the light emitting element 206 may be included on a rear surface of the screen display area of the display 201. In another embodiment (not shown), the display 201 may be incorporated with or disposed adjacent to a touch sensing circuit, a pressure sensor that measures the intensity (pressure) of a touch, and/or a digitizer that detects a magnetic field-based stylus pen. In a certain embodiment, at least some of the sensor modules 204 and 219 and/or at least some of the key input devices 217 may be disposed in the first regions 210D and/or the second regions 210E.

The audio modules 203, 207, and 214 may include a microphone hole 203 and speaker holes 207 and 214. A microphone for obtaining an external sound may be disposed in the microphone hole 203, and in a certain embodiment, a plurality of microphones may be disposed to detect the direction of sound. The speaker holes 207 and 214 may include an external speaker hole 207 and a receiver hole 214 for calls. In a certain embodiment, the speaker holes 207 and 214 and the microphone hole 203 may be implemented as a single hole, or a speaker (e.g., a piezo speaker) may be included without the speaker holes 207 and 214.

The sensor modules 204, 216, and 219 may generate an electrical signal or data value corresponding to an internal operating state of the electronic device 200 or an external environmental state. The sensor modules 204, 216, and 219 may include, for example, a first sensor module 204 (e.g., a proximity sensor) and/or a second sensor module (not shown) (e.g., a fingerprint sensor), disposed on the first surface 210A, and/or a third sensor module 219 (e.g., an HRM sensor) and/or a fourth sensor module (not shown) (e.g., a fingerprint sensor), disposed on the second surface 210B of the housing 210. The fingerprint sensor may be disposed on the second surface 210B as well as on the first surface 210A (e.g., the display 201). The electronic device 200 may further include at least one of, for example, a gesture sensor, a gyro sensor, a barometric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The camera modules 205, 212, and 213 may include a first camera device 205 disposed on the first surface 210A of the electronic device 200, and a second camera device 212 and/or a flash 213 disposed on the second surface 210B of the electronic device 200. The camera modules 205 and 212 may include one or more lenses, an image sensor, and/or an image signal processor. The flash 213 may include, for example, a light emitting diode (LED) or a xenon lamp. In a certain embodiment, two or more lenses (an IR camera, a wide-angle lens, and a telephoto lens) and image sensors may be arranged on one surface of the electronic device 200.

The key input devices 217 may be disposed on a side surface 210C of the housing 210. In another embodiment, the electronic device 200 may not include some or any of the above key input devices 217, and the key input devices 217 which are not included may be implemented in other forms such as soft keys on the display 201. In a certain embodiment, the key input devices may include the sensor module 216 disposed on the second surface 210B of the housing 210.

The light emitting element 206 may be disposed, for example, on the first surface 210A of the housing 210. The light emitting element 206 may provide, for example, state information about the electronic device 200 in the form of light. In another embodiment, the light emitting element 206 may provide, for example, a light source interworking with an operation of the camera module 205. The light emitting element 206 may include, for example, an LED, an IR LED, and a xenon lamp.

The connector holes 208 and 209 may include a first connector hole 208 that may accommodate a connector (e.g., a universal serial bus (USB) connector) for transmitting and receiving power and/or data to and from an external electronic device, and a second connector hole (e.g., an earphone jack) 209 for transmitting and receiving an audio signal to and from an external electronic device.

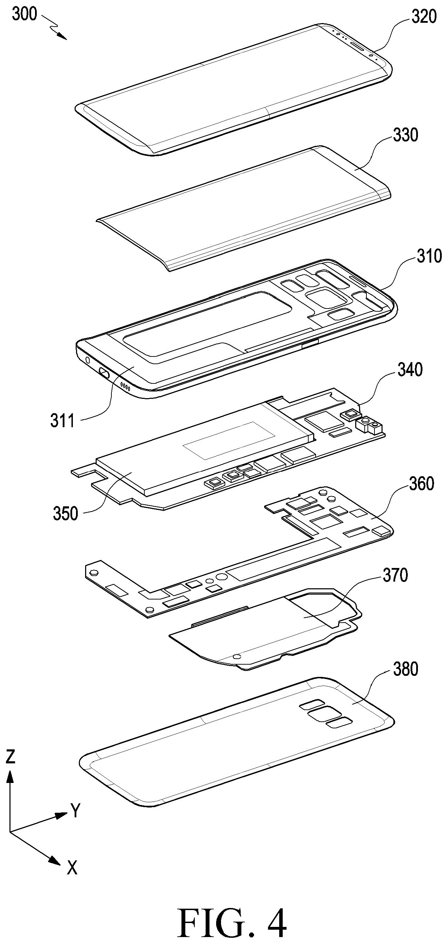

FIG. 4 is an exploded perspective view illustrating an electronic device 300 illustrated in FIG. 2.

Referring to FIG. 4, the electronic device 300 may include a side structure 310, a first support member 311 (e.g., a bracket), a front plate 320, a display 330, a PCB 340, a battery 350, a second support member 360 (e.g., a rear case), an antenna 370, and a rear plate 380. In a certain embodiment, the electronic device 300 may not be provided with at least one (e.g., the first support member 311 or the second support member 360) of the components or may additionally include other components. At least one of the components of the electronic device 300 may be the same as or similar to at least one of the components of the electronic device 200 of FIG. 2 or 3, and a redundant description will be avoided below.

The support member 311 may be disposed inside the electronic device 300 and connected to the side structure 310 or may be integrally formed with the side structure 310. For example, the first support member 311 may be formed of a metallic material and/or a non-metallic material (e.g., polymer). The first support member 311 may have one surface coupled to the display 330 and the other surface coupled to the PCB 340. A processor, memory, and/or an interface may be mounted on the PCB 340. The processor may include at least one of a CPU, an AP, a GPU, an ISP, a sensor hub processor, or a CP.

The memory may include, for example, volatile memory or non-volatile memory.

The interface may include, for example, a HDMI, a USB interface, an SD card interface, and/or an audio interface. The interface may, for example, electrically or physically connect the electronic device 300 to an external electronic device and include a USB connector, an SD card/MMC connector, or an audio connector.

The battery 350, which is a device that supplies power to at least one component of the electronic device 300, may include, for example, a non-rechargeable primary battery, a rechargeable secondary battery, or a fuel cell. At least a portion of the battery 350 may be disposed on substantially the same plane as, for example, the PCB 340. The battery 350 may be disposed integrally inside the electronic device 300 or detachably from the electronic device 300.

The antenna 370 may be disposed between the rear plate 380 and the battery 350. The antenna 370 may include, for example, a near field communication (NFC) antenna, a wireless charging antenna, and/or a magnetic secure transmission (MST) antenna. The antenna 370 may, for example, perform short-range communication with an external device or wirelessly transmit and receive power required for charging to and from an external device. In another embodiment, an antenna structure may be formed by a portion or combination of the side structure 310 and/or the first support member 311.

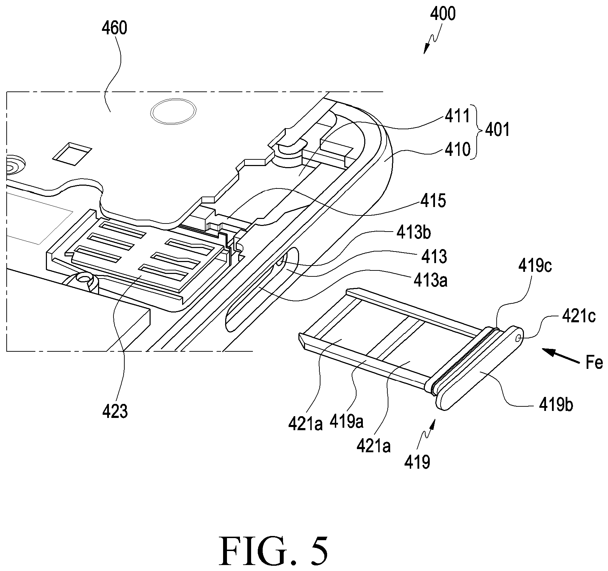

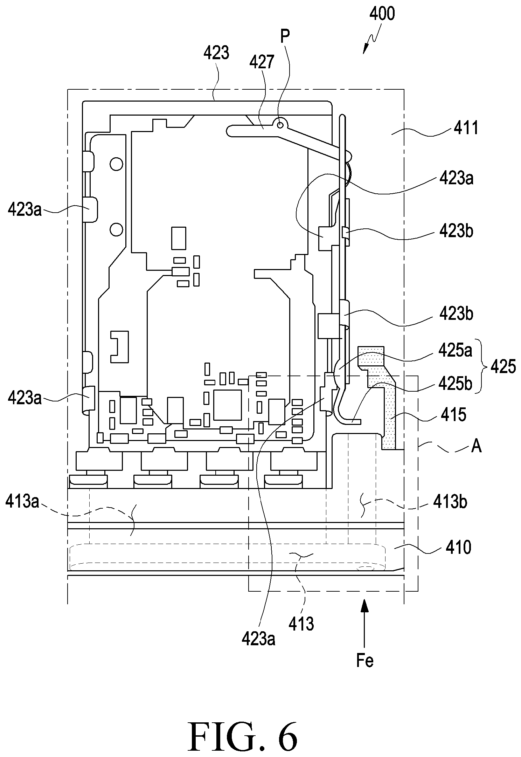

FIG. 5 is an exploded perspective view illustrating a portion of an electronic device 400 (e.g., the electronic devices 101, 102, 104, 200, and 300 in FIGS. 1 to 4) according to various embodiments of the disclosure. FIG. 6 is a plan view illustrating arrangement of a socket 423 in the electronic device 400 according to various embodiments of the disclosure.

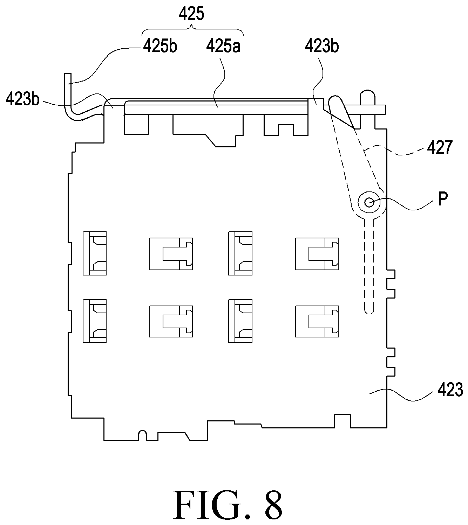

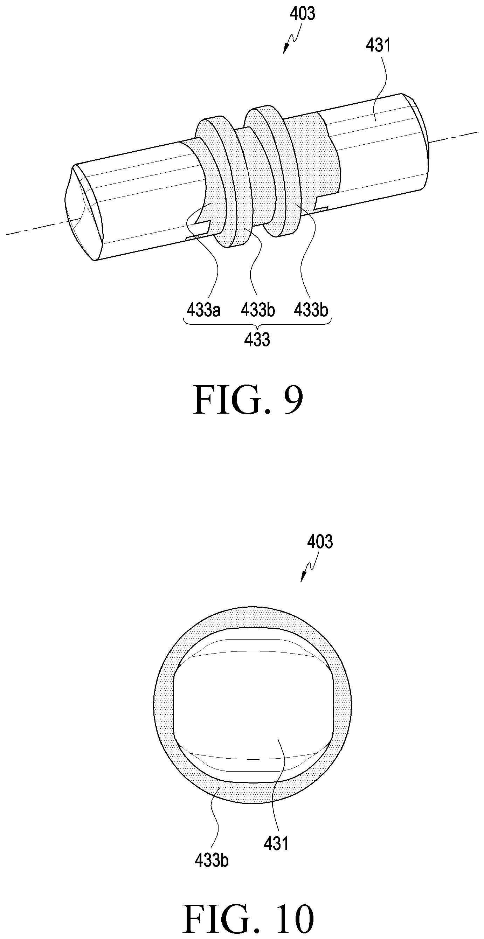

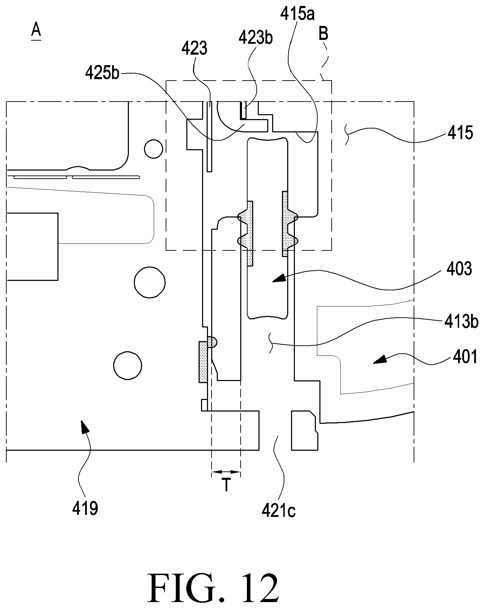

Referring to FIGS. 5 and 6, the electronic device 400 may include a housing 401 including a side structure 410 (e.g., the side structure 310 in FIG. 4) and a first support member 411 (e.g., the first support member 311 in FIG. 4), a protrusion 415 disposed inside the housing 401 or provided as a portion of the housing 401, the socket 423 disposed inside the housing 401, a push bar (e.g., a push bar 425 in FIG. 6 or 8) disposed as a storage medium separation structure on one side of the socket 423), and/or a waterproof pin (e.g., a waterproof pin 403 in FIG. 9 or 12). In an embodiment, the housing 401 may include a first through hole 413a and a second through hole 413b, and within the housing 401, the socket 423 may be aligned substantially with the first through hole 413a, the push bar 425 may be at least partially aligned with the second through hole 413b, and the waterproof pin 403 may be at least partially accommodated to be linearly reciprocable in the second through hole 413b. The waterproof pin 403 may form a sealing structure or a waterproof structure within the second through hole 413b, and be kept accommodated in the second through hole 413b by contacting the protrusion 415 in a reciprocating movement.

According to an embodiment, the housing 401 may include a second support member 460 (e.g., the second support member 360 in FIG. 4) coupled to the first support member 411 (e.g., the first support member 311 in FIG. 4), facing the first support member 411, and at least one circuit board (e.g., the PCB 340 in FIG. 4) may be disposed between the first support member 411 and the second support member 460. In an embodiment, the protrusion 415, which is a structure protruding from one surface of the first support member 411 (or the second support member 460), may be disposed adjacent to the second through hole 413b or the socket 423.

According to an embodiment, the first support member 411 may be disposed between the front surface (e.g., the first surface 210A in FIG. 2) and rear surface (e.g., the second surface 210B in FIG. 3) of the electronic device 400 or the housing 401, and the side structure 410 may be disposed to at least partially surround an area or space where the first support member 411 is disposed. For example, the housing 401 may accommodate or protect electrical/electronic components such as a circuit board or a battery (e.g., the battery 350 in FIG. 4) by forming a space between the front surface and rear surface of the electronic device 400. In an embodiment, in a plan view, the side structure 410 may have a closed curve or polygonal frame shape, and the first support member 411 may have a plate shape connected to the inside of the side structure 410. For convenience of description, the side structure 410 and the first support member 411 are described separately. However, this distinction does not limit various embodiments of the disclosure, and it is to be noted that the side structure 410 and the first support member 411 may be formed substantially integrally or partially omitted. For example, as mentioned above, the first support member 411 or the second support member 460 may be omitted, and the shape of the housing 401 may be appropriately designed according to specifications required for the electronic device to be actually manufactured.

According to an embodiment, the first through hole 413a may penetrate at least a portion of the side structure 410 from the outer surface of the side structure 410 (e.g., the side surface 220C in FIG. 2) and extend into an internal space of the housing 401. In an embodiment, the first through hole 413a may be used as a connector hole (e.g., the connector hole 208 or 209 in FIG. 2 or 3) or a sound hole for an audio module (e.g., the audio module 203, 207, or 214 in FIG. 2). In this embodiment, an example in which the first through hole 413a is provided as a connection hole for attaching or detaching a storage medium or a tray structure 419 for a storage medium may be disclosed. The 'storage medium' may include a memory card (e.g., the external memory 138 in FIG. 1) such as an SD card or a SIM card.

According to an embodiment, the second through hole 413b may be disposed on one side of the first through hole 413a, and may penetrate at least a portion of the side structure 410 from the outer surface (e.g., the side surface 220C in FIG. 2) of the side structure 410 and extend into the internal space of the housing 401. When the first through hole 413a functions as a connection hole for a storage medium, an external force Fe for separating the storage medium from the housing 401 may be provided through the second through hole 413b. For example, the second through hole 413b may function as an operation hole for separating the storage medium. As will be described later, the waterproof pin 403 may be disposed in the second through hole 413b to form a waterproof structure within the second through hole 413b.

According to an embodiment, when the first through hole 413a is provided as a connection hole for a storage medium, the electronic device 400 may further include the tray structure 419 inserted through the first through hole 413a. The socket 423 aligned with the first through hole 413a may accommodate at least a portion of the tray structure 419 or a storage medium disposed on the tray structure 419. The tray structure 419 may include a frame (e.g., an accommodation portion 419a) which is inserted into the housing 401 through the first through hole 413a and at least partially accommodated in the socket 423, and a tray header (e.g., a head portion 419b) provided at one end of the accommodation portion 419a. The accommodation portion 419a may have a frame shape that forms at least one accommodation groove 421a, and accommodate the storage medium (e.g., a memory card or a SIM card) using the storage groove 421a. For example, the accommodation portion 419a may be provided as a means for disposing the storage medium into the socket 423. The head portion 419b may hide the first through hole 413a and/or the second through hole 413b from the outside of the electronic device 400, and form a portion of the exterior of the electronic device 400, together with the side structure 410.

According to an embodiment, the electronic device 400 or the housing 401 may further include a recessed portion 413 formed on the outer surface (e.g., the side surface 220C in FIG. 2) of the side structure 410. The head portion 419b may be at least partially accommodated in the recessed portion 413. For example, with the tray structure 419 coupled to the housing 401, the head portion 419b may be accommodated in the recessed portion 413, and the outer surface of the head portion 419b may form a continuous flat surface or continuous curved surface with the outer surface of the side structure 410. In an embodiment, in the structure in which the recessed portion 413 is formed on the outer surface of the side structure 410, the first through hole 413a and/or the second through hole 413b may extend from the bottom or inner wall of the recessed portion 413 and be connected to the inside of the housing 401. For example, with the tray structure 419 coupled to the housing 401, the first through hole 413a and/or the second through hole 413b may be substantially concealed by the head portion 419b. In a certain embodiment, in a structure in which the external force Fe acts through the second through hole 413b to separate the storage medium or the tray structure 419, the head portion 419b may further include a tray hole 421c formed in alignment with the second through hole 413b. For example, when the tray structure 419 is coupled to the housing 401, the tray hole 421c may be disposed to correspond to the second through hole 413b and function as an operation hole to separate the storage medium, together with the second through hole 413b.

According to an embodiment, the electronic device 400 may further include a waterproof member 419c (e.g., a second waterproof ring separate from an elastic member 433 or a waterproof ring 433b in FIG. 9) disposed on the tray structure 419. The waterproof member 419c may be disposed around the frame (e.g., the accommodation portion 419a) at a position adjacent to the head portion 419b, and configured to contact or come into close contact with the inner wall of the first through hole 413a. For example, with the tray structure 419 coupled to the housing 401, a gap or space between the inner wall of the first through hole 413a and an outer peripheral surface of the accommodation portion 419a may be sealed by the waterproof member 419c, thereby forming a waterproof structure.

According to an embodiment, the socket 423 may be disposed on the circuit board (e.g., the PCB 340 in FIG. 3) or may be disposed adjacent to the circuit board and electrically connected to the circuit board through another electrical wiring (e.g., a flexible PCB). The socket 423 may be disposed inside the housing 401, with its inlet aligned with the first through hole 413a, and at least a portion of the tray structure 419 (e.g., the accommodation portion 419a) inserted through the first through hole 413a may be accommodated into the socket 423. In an embodiment, the electronic device 400 may further include a storage medium separation structure (e.g., the push bar 425 and/or a pivot member 427) disposed on one side of the socket 423. The storage medium separation structure may separate or discharge the tray structure 419 from the socket 423 using the external force Fe applied through the second through hole 413b. For example, one end (e.g., a bent portion 425b of the push bar 425) of the storage medium separation structure may be aligned to at least partially face the second through hole 413b or the waterproof pin 403 of FIG. 9.

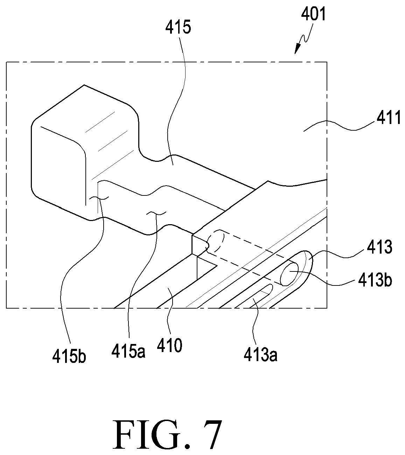

According to an embodiment, the waterproof pin 403 may transmit the external force Fe applied through the tray hole 421c to the storage medium separation structure, while forming a waterproof structure inside the second through hole 413b. According to an embodiment, a distance or range that the waterproof pin 403 may move inside the housing 401 may be limited by contacting the protrusion 415. For example, in an operation of transmitting the external force Fe to the storage medium separation structure, the waterproof pin 403 or a waterproof ring (e.g., waterproof rings 433b in FIG. 9) of the waterproof pin 403 may be kept substantially accommodated in the second through hole 413b, thereby suppressing or preventing damage to the waterproof ring during a linearly reciprocating movement. The structure of the protrusion 415 will be described further with reference to FIG. 7.

FIG. 7 is a perspective view illustrating the protrusion 415 in an electronic device (e.g., the electronic device 400 in FIG. 5) according to various embodiments of the disclosure.

Referring further to FIG. 7, the protrusion 415 may protrude from one surface of the first support member 411 (or the second support member 460) and be disposed adjacent to the second through hole 413b (or the socket 423). In an embodiment, a portion of the protrusion 415 may be disposed to substantially face the second through hole 413b. For example, when the waterproof pin 403 moves along a direction in which the second through hole 413b extends or along a direction in which the external force Fe is applied, a portion of the waterproof pin 403 may contact the protrusion 415. In an embodiment, in a portion facing the second through hole 413b, the protrusion 415 may include an interference region 415a in contact with the waterproof pin 403 and a seating region 415b formed adjacent to the interference region 415a. As will be described later, the waterproof pin 403 may no longer move into the housing 401 by contacting the interference region 415a, and when the waterproof pin 403 contacts the interference region 415a, a portion of the push bar 425 may be accommodated on or contact the seating region 415b. According to an embodiment, the push bar 425 may no longer be able to move in a direction away from the second through hole 413b due to contacting the protrusion 415 in the seating region 415b.

In the following detailed description, reference may be made to the electronic devices 101, 102, 104, 200, 300, and 400 of the preceding embodiments, and it is to be noted that components that may be easily understood through the preceding embodiments are indicated by the same reference numerals or no reference numerals, and their detailed description may also be avoided.

FIG. 8 is a bottom view illustrating the socket 423 and/or the storage medium separation structure 425 and 427 in an electronic device (e.g., the electronic device 400 in FIG. 4) according to various embodiments of the disclosure.

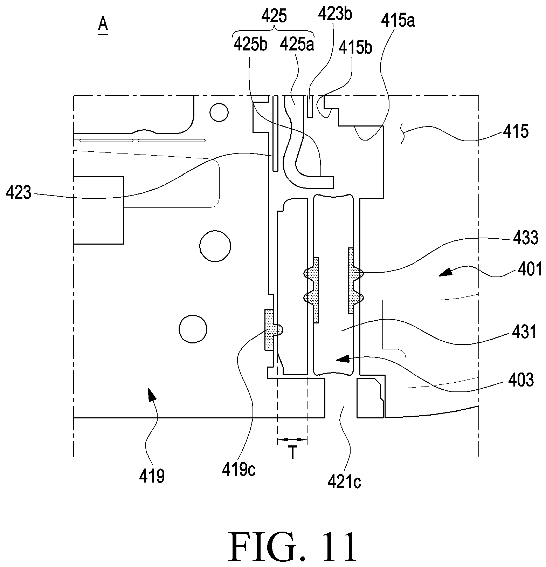

Referring to FIG. 8 together with FIG. 6, the electronic device 400 may include the push bar 425 disposed adjacent to the socket 423 and the pivot member 427 pivotably disposed on the socket 423. The push bar 425 and the pivot member 427 may separate or discharge the storage medium or the tray structure (e.g., the tray structure 419 in FIG. 5) accommodated in the socket 423 based on an external force. For example, the push bar 425 and the pivot member 427 may be provided as the storage medium separation structure. According to an embodiment, the push bar 425 may include an extension portion 425a disposed on one side of the socket and making a linearly reciprocating movement, and the bent portion 425b bent from one end of the extension portion 425a and disposed to at least partially face the second through hole 413b. A direction of the linearly reciprocating movement of the push bar 425a or the extension portion 425a may be substantially parallel to the direction in which the second through hole 413b extends, the direction in which the external force Fe of FIG. 5 or 6 is applied, and/or a direction in which the waterproof pin (e.g., the waterproof pin 403 in FIG. 11 or 12 makes a linearly reciprocating movement. However, various embodiments of the disclosure are not limited to thereto, and the direction of the linearly reciprocating movement of the push bar 425 or the extension portion 425a may be inclined with respect to the direction(s) described above.

According to an embodiment, the electronic device 400 or the socket 423 may include at least one guide rib 423a and/or at least one guide hook 423b. The guide rib 423a may guide the movement of the tray structure 419, for example, in an insertion or separation operation of the tray structure 419, and the guide hook 423b may guide the linearly reciprocating movement of the push bar 425 or the extension portion 425a. In a certain embodiment, the push bar 425 may be coupled to the socket 423 in a state where the push bar 425 is linearly reciprocable by the guide hook(s) 423b. In an embodiment, the socket 423 may include a case made by bending or sheet-metal-processing a metal plate, and the guide rib 423a or the guide hook 423b may be a portion of the metal plate provided as the case. For example, although described separately for convenience of description, the guide rib 423a and the guide hook 423b, which are structures bent to surround a portion of the tray structure 419 or the push bar 425, may be portions of the metal plate that substantially forms the case of the socket 423.

According to an embodiment, the pivot member 427, which is a portion of the storage medium separation structure, may be disposed to be pivotable around a pivot axis P inside the socket 423. Although not assigned a reference number, the pivot member 427 may include a pair of pivot arms extending in directions away from the pivot axis P, and may be disposed such that one of the pivot arms is connected to the push bar 425 (e.g., the extension portion 425a) on one side of the pivot axis P, and the other of the rotation arms is disposed to contact the tray structure 419 on the other side of the pivot axis P. In the structure illustrated in FIG. 6, when the external force Fe is applied, the push bar 425 may move upward by the waterproof pin 403 and pivot the pivot member 427 in a counterclockwise direction, and the tray structure 419 coupled to the inside of the socket 423 may be separated or discharged by moving downward with respect to the socket 423 by the pivot member 427. According to an embodiment, when a user couples the tray structure 419 to the socket 423, the pivot member 427 of FIG. 6 may pivot in a clockwise direction by the tray structure 419 and move the push bar 425 downward. When the push bar 425 moves downward, the waterproof pin 403 may move into the second through hole 413b. The structure and arrangement of the waterproof pin 403 will be described with reference to FIGS. 9 to 14.

FIG. 9 is a perspective view illustrating the waterproof pin 403 in an electronic device (e.g., the electronic devices 101, 102, 104, 200, 300, and 400 in FIGS. 1 to 6) according to various embodiments of the disclosure. FIG. 10 is a front view illustrating the waterproof pin 403 in the electronic device 400 according to various embodiments of the disclosure.

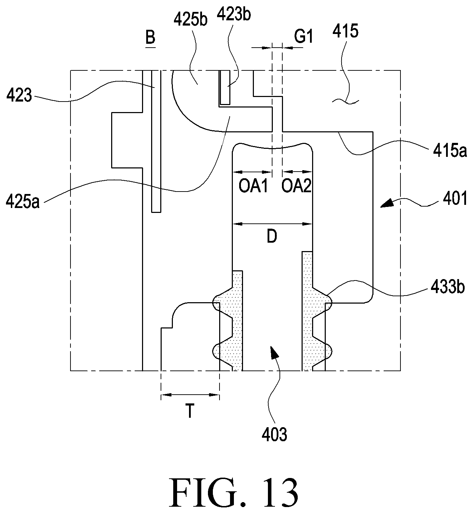

First, referring to FIGS. 9 and 10, the waterproof pin 403 may include a pin member 431 and the elastic member 433. The pin member 431 may extend, for example, along the direction in which the second through hole 413a extends or the direction of a linearly reciprocating movement within the second through hole 413b, and transmit an external force by contacting the push bar 425 (e.g., the bent portion 425b) in the storage medium separation operation. According to an embodiment, a partial area (e.g., a first region OA1 in FIG. 13) of the surface of one end of the waterproof pin 403 (e.g., the pin member 431) may contact the push bar 425 (e.g., the bent portion 425b in FIG. 8), and when the partial area reaches a specified position, another area (e.g., a second region OA2 in FIG. 13) of the surface of the one end of the waterproof pin 403 may contact the protrusion (e.g., the protrusion 415 or the interference region 415a in FIG. 7).

According to an embodiment, the elastic member 433 may include a fixing portion 433a coupled to surround the outer peripheral surface of the pin member 431, and at least one waterproof ring 433b protruding from the outer peripheral surface of the fixing portion 433a or the pin member 431. The pin member 431 and the elastic member 433 may be molded using double injection or insert injection, and the elastic member 433 may be coupled to the outer peripheral surface of the pin member 431 simultaneously with being molded. In the illustrated embodiment, a portion of the outer peripheral surface of the pin member 431 may have a groove shape for accommodating the fixing portion 433a, and the fixing portion 433a may be disposed to substantially form a continuous curved surface or flat surface with another area of the outer peripheral surface of the pin member 431. For example, the fixing portion 433a may provide a binding force between the elastic member 433 and the pin member 431, and the external shape of the fixing portion 433a may appear to be substantially a portion of the pin member 431. In another embodiment, when a sufficient binding force may be secured, the fixing portion 433a may be omitted from the elastic member 433, and the waterproof ring 433b itself may be coupled to the pin member 431. The shape or coupling structure of the elastic member 433 or the waterproof ring 433b may be selected appropriately in consideration of specifications (e.g., waterproof performance, or frictional force in the operation of transmitting the external force Fe) required for the electronic device 400. As will be described later, the elastic member 433 (e.g., the waterproof ring 433b) may form a sealing structure or a waterproof structure within the second through hole 413b or between the inner wall of the second through hole 413b and the outer peripheral surface of the pin member 431 by contacting or coming into close contact with the inner wall of the second through hole 413b.

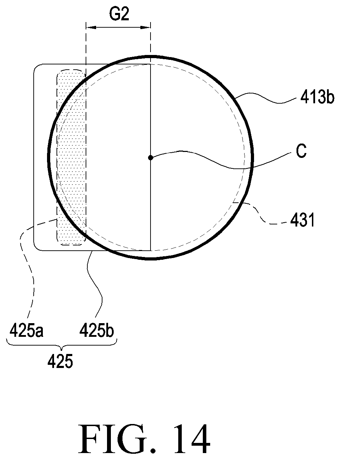

FIG. 11 is a configuration diagram illustrating a state before an external force (e.g., the external force Fe in FIG. 5 or 6) is applied to the waterproof pin 403 or the storage medium separation structure in an electronic device (e.g., the electronic devices 101, 102, 104, 200, 300, and 400 in FIGS. 1 to 6) according to various embodiments of the disclosure. FIG. 12 is a configuration diagram illustrating a state after an external force (e.g., the external force Fe in FIG. 5 or 6) is applied to the waterproof pin 403 or the storage medium separation structure in the electronic device 400 according to various embodiments of the disclosure. FIG. 13 is an enlarged view illustrating a part 'B' of FIG. 12. FIG. 14 is a diagram illustrating the arrangement of the storage medium separation structure (e.g., the push bar 425) in the electronic device 400 according to various embodiments of the disclosure.

FIGS. 11 and 12 are enlarged views illustrating a part 'A' of FIG. 6 before and after the external force Fe is applied, and FIG. 14 illustrates an exemplary structure in which the second through hole 413b and the push bar 425 are disposed, when viewed along the direction in which the external force Fe is applied or the direction in which the waterproof pin 403 (e.g., the pin member 431) makes a linearly reciprocating movement. An embodiment described with reference to FIGS. 11 to 14 is related to an exemplary movement or arrangement relationship between components in a storage medium separation operation, and it is to be noted that various embodiments of the disclosure are not limited thereto.

Referring to FIGS. 11 and 12, in applying a waterproof structure, for example, in disposing the waterproof pin 403, a metal or polymer structure of a specified thickness T may be disposed between the first through hole (e.g., the first through hole 413a in FIG. 6 or 7) and the second through hole 413b (e.g., the second through hole 413b in FIG. 6 or 7), in consideration of an elastic force of the elastic member 433 or the waterproof ring (e.g., the waterproof ring 433b in FIG. 9). This metal or polymer structure may be a portion of the side structure (e.g., the side structure 410 in FIG. 5 or 6) or the housing 401. The thickness T may be appropriately selected by taking in account the properties of a material forming the housing 401 or the side structure 401 of FIG. 6 and a mechanical strength corresponding to an elastic force generated by the elastic member 433 or the waterproof ring 433b in forming the waterproof structure. Since no elastic force substantially acts on the inner wall of the second through hole 413b when the waterproof structure is not applied, the thickness T may be smaller than in the illustrated embodiment or may be omitted.

According to an embodiment, through the push bar 425, an external force may be transmitted to a portion of the bent portion 425b. When the bent portion 425b is smaller in miniaturizing connection components (e.g., the socket 423 and/or the storage medium separation structure), an area (e.g., the first region OA1 in FIG. 13) in which the bent portion 425b and the second through hole 413b or the bent portion 425b and the waterproof pin 403 (e.g., the pin member 431) may be aligned to face each other may be limited. For example, as will be described with reference to FIG. 14, when a gap (e.g., the thickness T) equal to the thickness T is formed between the first through hole 413a and the second through hole 413b, the miniaturized bent portion 425b and the second through hole 413b (or the waterproof pin 403) may be partially misaligned. According to an embodiment, even if the bent portion 425b and the second through hole 413b are partially misaligned, the waterproof pin 403 may enable the external force Fe to be stably transmitted to the push bar 425 or the bent portion 425b. For example, when a plurality of waterproof rings 433b are disposed and come into close contact with or supported by the inner wall of the second through hole 413b, the waterproof pin may make a linearly reciprocating movement within the second through hole 413b while maintaining alignment with the push bar 425 or the bent portion 425b.

According to an embodiment, at a specified position, for example, in a state in which the push bar 425 moves by the external force Fe and separates the tray structure 419 at least partially from the socket 423, a portion of the waterproof pin 403 may contact the protrusion 415 (e.g., the interference region 415a). For example, in a state where the tray structure 419 protrudes from the housing 401 to the extent that the user may directly separate it from the housing 401, the waterproof pin 403 may not move further into the housing 401 from the second through hole 413b. According to an embodiment, with a portion of the waterproof pin 403 in contact with the protrusion 415, the waterproof ring(s) 433b may be substantially or at least partially located within the second through hole 413b.

According to an embodiment, when one of the waterproof rings 433b deviates from the second through hole 413b during a linearly reciprocating movement of the waterproof pin 403, there may be a change in an inclination angle of the waterproof pin 403 relative to the push bar 425 due to the movement of the waterproof pin 403. For example, the waterproof pin 403 may fail to maintain the contact with the push bar 425 (e.g., the bent portion 425b), so that the external force Fe is not properly transmitted to the push bar 425 in a subsequent operation, or the push bar 425 may not be able to return the waterproof pin 403 to the second through hole 413b. In various embodiments of the disclosure, as the protrusion 415 (e.g., the interference region 415a) limits a movement range of the waterproof pin 403, and thus maintains the alignment between the waterproof pin 403 and the push bar 425, the storage medium separation operation or the operation of returning the waterproof pin 403 to the second through hole 413b may be stabilized.

According to an embodiment, even if the alignment between the waterproof pin 403 and the push bar 425 is maintained, when any one of the waterproof rings 433b deviates from the second through hole 413b, the waterproof ring(s) 433b may be damaged due to interference from a structure around the second through hole 413b in the process of the waterproof pin 403 returning to the second through hole 413b. For example, waterproofing performance using the waterproof pin 403 may deteriorate. In various embodiments of the disclosure, as the waterproof ring(s) 433b are substantially located inside the second through hole 413b at the position where the waterproof pin 403 is in contact with the protrusion 415, damage to the waterproof ring(s) 433b may be prevented in the process of the waterproof pin 403 returning to the second through hole 413b, and the deterioration of waterproofing performance may be suppressed.

According to an embodiment, one of the guide hooks 423b guides or supports the linearly reciprocating movement of the push bar 425 (e.g., the extension portion 425a), and when reaching a position where the waterproof pin 403 is in contact with the protrusion 415, may interfere with the bent portion 425b, as illustrated in FIG. 12. For example, one of the guide hooks 423b may limit a movement range of the push bar 425 moving in the direction away from the second through hole 413b. In an embodiment, when the waterproof pin 403 reaches a position where it contacts the protrusion 415, the push bar 425 (e.g., the bent portion 425b) may be at least partially accommodated in the seating region 415b and directly contact the protrusion 415. In a certain embodiment, the bent portion 425b may contact the protrusion 415 (e.g., the seating region 415b) before the guide hook 423b. For example, when the bent portion 425b interferes with the guide hook 423b, an external force (e.g., the external force Fe in FIG. 5 or 6) may be applied to the socket 423, and the bent portion 425b may contact the protrusion 415 before the guide hook 423b, thereby alleviating or preventing the external force applied to the socket 423.

Referring to FIGS. 13 and 14, the waterproof pin 403 may include the first region OA1 configured to contact the push bar 425 (e.g., the bent portion 425b) and the second region OA2 configured to contact the protrusion 415 (e.g., the interference region 415a), on one end surface thereof, and the second region OA2 may have a smaller area or width than the first region OA1. In an embodiment, the first region OA1 may have an area of approximately 50% of the area of the surface of one end of the waterproof pin 403 (e.g., the pin member 431) or a width of approximately 50% of the diameter of the surface of one end of the waterproof pin 403. For example, when the diameter of the waterproof pin 403 is approximately 1.3mm, the width of the first region OA1 in a radial direction from the outer peripheral surface of the waterproof pin 403 may be approximately 0.6mm to 0.7mm. According to an embodiment, the second region OA2 may have an area of approximately 25% to 30% of the area of the surface of one end of the waterproof pin 403 or a width of approximately 25% to 30% of the diameter of the end surface of the waterproof pin 403. For example, when the diameter of the waterproof pin 403 is approximately 1.3mm, the width of the second region OA2 in the radial direction from the outer peripheral surface of the waterproof pin 403 may be approximately 0.3mm to 0.4mm. In a certain embodiment, when the diameter of the waterproof pin 403 is approximately 1.3mm, a first gap G1 of approximately 0.3mm may be formed between the first region OA1 and the second region OA2. For example, with the waterproof pin 403 in contact with the protruding portion 415, the bent portion 425b may be located at a distance of approximately 0.3mm from the interference region 415a.

According to an embodiment, when viewed from the direction in which the external force Fe of FIG. 6 is applied or the direction in which the waterproof pin 403 linearly reciprocates, the extension portion 425a may be disposed at a specified second gap G2 from a center C of the second through hole 413b, and the bent portion 425b may be disposed to at least partially overlap the second through hole 413b, as illustrated in FIG. 14. When the area or width of the first region OA1 is approximately 50% of that of the surface of the one end of the waterproof pin 403 (e.g., the pin member 431) in FIG. 13, the bent portion 425b may be disposed to overlap the second through hole 413b by approximately 50% of the diameter of the hole 413b in FIG. 14. According to an embodiment, as the waterproof pin 403 linearly reciprocates substantially parallel to the direction in which the external force Fe is applied or the direction in which the push bar 425 (e.g., the extension portion 425a) extends, the waterproof pin 403 may stably transmit the external force Fe to the push bar 425, and as the waterproof pin 403 reaches a specified position on the second through hole 413b and contacts the protrusion 415, changes in the area or width of the first region OA1 contacting the push bar 425 may be suppressed.

As such, the electronic device 400 according to various embodiments of the disclosure may stably perform a storage medium separation operation, while applying a waterproof structure, even when the waterproof structure is combined with a miniaturized connection component (e.g., the socket 423 or the storage medium separation structure disposed adjacent to the socket 423 in FIG. 6 or 8). For example, it is possible to suppress an increase in manufacturing cost or component management cost while applying a waterproof structure, by providing an environment in which miniaturized connection components may be standardized. In an embodiment, as a structure (e.g., the protrusion 415 in FIG. 7 or 12) limiting the movement range of the waterproof pin 403 is provided in the housing 401, the alignment of the waterproof pin 403 and the storage medium separation structure may be stably maintained, and the waterproofing performance may be stably maintained by preventing damage to the waterproof ring 433b in the operation of returning the waterproof pin 403 to the through hole (e.g., the second through hole 413b in FIG. 12) of the housing 401.

As described above, according to an embodiment of the disclosure, an electronic device (e.g., the electronic devices 101, 102, 104, 200, 300, and 400 in FIGS. 1 to 6) may include a housing (e.g., the housing 210 or 401 in FIG. 2 or 5) including a first through hole (e.g., the first through hole 413a in FIG. 5 or 6) formed to penetrate a side surface (e.g., the side surface 220C in FIG. 2 or the side structures 310 and 410 in FIGS. 4 and 5) and a second through hole (e.g., the second through hole 413b in FIG. 5 or 6) disposed adjacent to the first through hole and formed to penetrate the side surface, a protrusion (e.g., the protrusion 415 in FIGS. 5 to 7 or FIG. 12) disposed inside the housing to at least partially face the second through hole, a socket (e.g., the socket 423 in FIG. 5, 6 or 8) disposed inside the housing and aligned with the first through hole, a push bar (e.g., the push bar 425 in FIG. 6 or 8) disposed on one side of the socket to be linearly reciprocable and at least partially aligned with the second through hole, and a waterproof pin (e.g., the waterproof pin 403 in FIGS. 9 to 13) sealing the second through hole by being accommodated in the second through hole, and configured to move the push bar by linearly reciprocating within the second through hole by an external force. In an embodiment, the waterproof pin may be configured to, when reaching a specified position on the second through hole, contact the push bar in a first region (e.g., the first region OA1 in FIG. 13) of a surface of one end of the waterproof pin, and contact the protrusion in a second region (e.g., the second region OA2 in FIG. 13) of the surface of the one end of the waterproof pin, the second region is different from the first region.

According to an embodiment, the waterproof pin may include a pin member (e.g., the pin member 431 in FIG. 9 or 10) extending along a direction of the linearly reciprocating movement within the second through hole, and at least one first waterproof ring (e.g., the waterproof ring 433b in FIG. 9 or 10) protruding from an outer peripheral surface of the pin member, and the first waterproof ring may be configured to seal a space or a gap between the outer peripheral surface of the pin member and an inner wall of the second through hole.

According to an embodiment, when the waterproof pin reaches the specified position on the second through hole, the first waterproof ring may be at least partially located within the second through hole.

According to an embodiment, the first region may be configured to contact the push bar by a first area, and the second region is configured to contact the protrusion by a second area smaller than the first area.

According to an embodiment, the protrusion may include an interference region (e.g., the interference region 415a in FIG. 7 or 13) configured to contact the second region of the waterproof pin, and a seating region (e.g., the seating region 415b in FIG. 7 or 11) formed adjacent to the interference region, and configured to accommodate at least a portion of the push bar, when the waterproof pin contacts the interference region.

According to an embodiment, the push bar may be configured to move in a direction away from the second through hole by the waterproof pin and stop by being interfered by the protrusion in the seating region.

According to an embodiment, the electronic device may further include a tray structure (e.g., the tray structure 419 in FIG. 5) configured to be detachably attached to the housing through the first through hole, and the tray structure may be at least partially accommodated in the socket inside the housing.

According to an embodiment, the tray structure may include a tray header (e.g., the head portion 419b) disposed to at least partially form a continuous curved surface or a continuous flat surface with the side surface, while being mounted in the housing, a frame (e.g., the accommodation portion 419a in FIG. 5) configured to extend from an inner surface of the tray header and be accommodated into the housing through the first through hole, and at least one second waterproof ring (e.g., the waterproof member 419c in FIG. 5) protruding from an outer peripheral surface of the frame at a position adjacent to the tray header. The second waterproof ring may be configured to seal a space or a gap between the outer peripheral surface of the frame and an inner wall of the first through hole.

According to an embodiment, the electronic device may further include a pivot member (e.g., the pivot member 427 in FIG. 6 or 8) pivotably coupled to the socket, and the pivot member may be configured to separate the tray structure from the socket by pivoting on the socket by the push bar.

According to an embodiment, the push bar may include an extension portion (e.g., the extension portion 425a in FIG. 6 or 8) disposed on one side of the socket and extending along a direction of the linearly reciprocating movement, and a bent portion (e.g., the bent portion 425b in FIG. 6 or 8) bent from one end of the extension portion and disposed to at least partially face the second through hole. The waterproof pin may be configured to contact the bent portion.

According to an embodiment, when viewed along a direction of the linearly reciprocating movement of the waterproof pin, the extension portion may be disposed at a predetermined gap (e.g., the second gap G2 in FIG. 14) from a center of the second through hole, and the bent portion may be disposed to at least partially overlap the second through hole.

According to an embodiment, the electronic device may further include a plurality of guide hooks (e.g., the guide hooks 423b in FIG. 6 or 8) extending from one side of the socket, and the extension portion may be configured to linearly reciprocate on the one side of the socket, while being guided or supported by the guide hooks.

According to an embodiment, when the waterproof pin reaches the specified position on the second through hole, a portion of the bent portion may be configured to be interfered by one of the guide hooks.

According to an embodiment of the disclosure, an electronic device (e.g., the electronic devices 101, 102, 104, 200, 300, and 400 in FIGS. 1 to 6) may include a housing (e.g., the housing 210 or 401 in FIG. 2 or 5) including a first through hole (e.g., the first through hole 413a in FIG. 5 or 6) formed to penetrate a side surface (e.g., the side surface 220C in FIG. 2 or the side structures 310 and 410 in FIGS. 4 and 5) and a second through hole (e.g., the second through hole 413b in FIG. 5 or 6) disposed adjacent to the first through hole and formed to penetrate the side surface, a protrusion (e.g., the protrusion 415 in FIGS. 5 to 7 or FIG. 12) disposed inside the housing to at least partially face the second through hole, a socket (e.g., the socket 423 in FIG. 5, 6 or 8) disposed inside the housing and aligned with the first through hole, a push bar (e.g., the push bar 425 in FIG. 6 or 8) disposed on one side of the socket to be linearly reciprocable and at least partially aligned with the second through hole, and a waterproof pin (e.g., the waterproof pin 403 in FIGS. 9 to 13) accommodated in the second through hole to be linearly reciprocable and configured to move the push bar based on an external force. In an embodiment, the waterproof pin may include a pin member (e.g., the pin member 431 in FIG. 9 or 10) extending along a direction of a linearly reciprocating movement within the second through hole, and at least one first waterproof ring (e.g., the waterproof rings 433b in FIG. 9 or 10) protruding from an outer peripheral surface of the pin member and configured to seal a space or a gap between the outer peripheral surface of the pin member and an inner wall of the second through hole. When the waterproof pin reaches a specified position on the second through hole, a portion of the waterproof pin may contact the protrusion, and the first waterproof ring may be at least partially located within the second through hole.

According to an embodiment, the protrusion may include an interference region (e.g., the interference region 415a in FIG. 7 or 13) configured to contact a portion of the waterproof pin, and a seating region (e.g., the seating region 415b in FIG. 7 or 11) formed adjacent to the interference region, and configured to accommodate at least a portion of the push bar, when the waterproof pin contacts the interference region.

According to an embodiment, the electronic device may further include a tray structure (e.g., the tray structure 419 in FIG. 5) configured to be detachably attached to the housing through the first through hole, and the tray structure may be at least partially accommodated in the socket inside the housing.

According to an embodiment, the electronic device may further include a pivot member (e.g., the pivot member 427 in FIG. 6 or 8) pivotably coupled to the socket, and the pivot member may be configured to separate the tray structure from the socket by pivoting on the socket by the push bar.

According to an embodiment, the push bar may include an extension portion (e.g., the extension portion 425a in FIG. 6 or 8) disposed on one side of the socket and extending along a direction of the linearly reciprocating movement, and a bent portion (e.g., the bent portion 425b in FIG. 6 or 8) bent from one end of the extension portion and disposed to at least partially face the second through hole. The waterproof pin may be configured to contact the bent portion.

According to an embodiment, when viewed along a direction of the linearly reciprocating movement of the waterproof pin, the extension portion may be disposed at a predetermined gap (e.g., the second gap G2 in FIG. 14) from a center of the second through hole, and the bent portion may be disposed to at least partially overlap the second through hole.

According to an embodiment, when the waterproof pin reaches the specified position on the second through hole, the waterproof pin may be configured to contact the bent portion by a first area, and contact the protrusion by a second area smaller than the first area.

While the disclosure has been described with reference to various embodiments by way of example, it should be understood that the various embodiments are for illustrative purposes only and not intended to limit the disclosure. It will be apparent to those skilled in the art that various changes may be made in the form and detailed structure of the disclosure, without departing from the scope of the appended claims.

## Claims

1. An electronic device (101, 200, 400) comprising:
a housing (210, 401) including a first through hole (413a) formed to penetrate a side surface (210C, 410) and a second through hole (413b) disposed adjacent to the first through hole and formed to penetrate the side surface;
a protrusion (415) disposed inside the housing to at least partially face the second through hole;
a socket (423) disposed inside the housing and aligned with the first through hole;
a push bar (425) disposed on one side of the socket to be linearly reciprocable and at least partially aligned with the second through hole; and
a waterproof pin (403) sealing the second through hole by being accommodated in the second through hole, and configured to move the push bar by linearly reciprocating within the second through hole by an external force,
wherein the waterproof pin is configured to, when reaching a specified position on the second through hole, contact the push bar in a first region of a surface of one end of the waterproof pin, and contact the protrusion in a second region of the surface of the one end of the waterproof pin, the second region being different from the first region.

2. The electronic device (101, 200, 400) of claim 1, wherein the waterproof pin (403) includes:
a pin member extending along a direction of the linearly reciprocating movement within the second through hole (413b); and
at least one first waterproof ring protruding from an outer peripheral surface of the pin member,
wherein the first waterproof ring is configured to seal a space or a gap between the outer peripheral surface of the pin member and an inner wall of the second through hole.

3. The electronic device (101, 200, 400) of claim 2, wherein when the waterproof pin (403) reaches the specified position on the second through hole (413b), the first waterproof ring is at least partially located within the second through hole.

4. The electronic device (101, 200, 400) of claim 1, wherein the first region is configured to contact the push bar (425) by a first area, and the second region is configured to contact the protrusion (415) by a second area smaller than the first area.

5. The electronic device (101, 200, 400) of claim 1, wherein the protrusion (415) includes:
an interference region configured to contact the second region of the waterproof pin (403); and
a seating region formed adjacent to the interference region, and configured to accommodate at least a portion of the push bar (425), when the waterproof pin contacts the interference region.

6. The electronic device (101, 200, 400) of claim 5, wherein when the second region of the waterproof pin (403) contacts the interference region, the at least a portion of the push bar (425) is configured to be accommodated in the seating region.

7. The electronic device (101, 200, 400) of claim 5, wherein the push bar (425) is configured to move in a direction away from the second through hole (413b) by the waterproof pin (403) and stop by being interfered by the protrusion (415) in the seating region.

8. The electronic device (101, 200, 400) of claim 1, further comprising a tray structure configured to be detachably attached to the housing (210, 401) through the first through hole (413a),
wherein the tray structure is at least partially accommodated in the socket (423) inside the housing.

9. The electronic device (101, 200, 400) of claim 8, wherein the tray structure includes:
a tray header disposed to at least partially form a continuous curved surface or a continuous flat surface with the side surface (210C, 410), while being mounted in the housing (210, 401);
a frame configured to extend from an inner surface of the tray header and be accommodated into the housing through the first through hole (413a); and
at least one second waterproof ring protruding from an outer peripheral surface of the frame at a position adjacent to the tray header,
wherein the second waterproof ring is configured to seal a space or a gap between the outer peripheral surface of the frame and an inner wall of the first through hole.

10. The electronic device (101, 200, 400) of claim 8, further comprising a pivot member pivotably coupled to the socket (423),
wherein the pivot member is configured to separate the tray structure from the socket by pivoting on the socket by the push bar (425).

11. The electronic device (101, 200, 400) of claim 10, wherein the pivot member is configured to pivot by the push bar (425), as the waterproof pin (403) moves in a direction in which the second region contacts the protrusion (415).

12. The electronic device (101, 200, 400) of claim 1, wherein the push bar (425) includes:
an extension portion disposed on one side of the socket (423) and extending along a direction of the linearly reciprocating movement; and
a bent portion bent from one end of the extension portion and disposed to at least partially face the second through hole (413),
wherein the waterproof pin (403) is configured to contact the bent portion.

13. The electronic device (101, 200, 400) of claim 12, wherein when viewed along a direction of the linearly reciprocating movement of the waterproof pin (403), the extension portion is disposed at a predetermined gap from a center of the second through hole (413b), and the bent portion is disposed to at least partially overlap the second through hole.

14. The electronic device (101, 200, 400) of claim 12, further comprising a plurality of guide hooks extending from one side of the socket (423),
wherein the extension portion is configured to linearly reciprocate on the one side of the socket, while being guided or supported by the guide hooks.

15. The electronic device (101, 200, 400) of claim 14, wherein when the waterproof pin (403) reaches the specified position on the second through hole (413b), a portion of the bent portion is configured to be interfered by one of the guide hooks.

## Patentansprüche

1. Elektronische Vorrichtung (101, 200, 400), umfassend:
ein Gehäuse (210, 401), das ein erstes Durchgangsloch (413a), das dazu ausgebildet ist, eine Seitenoberfläche (210C, 410) zu durchdringen, und ein zweites Durchgangsloch (413b) enthält, das benachbart zu dem ersten Durchgangsloch angeordnet und dazu ausgebildet ist, die Seitenoberfläche zu durchdringen;
einen Vorsprung (415), der innerhalb des Gehäuses angeordnet ist, um mindestens teilweise dem zweiten Durchgangsloch zugewandt zu sein;
eine Buchse (423), die innerhalb des Gehäuses angeordnet und mit dem ersten Durchgangsloch ausgerichtet ist;
eine Schubstange (425), die auf einer Seite der Buchse angeordnet ist, um linear hin- und herbewegbar zu sein, und mindestens teilweise mit dem zweiten Durchgangsloch ausgerichtet ist; und
einen wasserdichten Stift (403), der das zweite Durchgangsloch abdichtet, indem er in dem zweiten Durchgangsloch untergebracht ist, und dazu konfiguriert ist, die Schubstange durch lineares Hin- und Herbewegen innerhalb des zweiten Durchgangslochs durch eine externe Kraft zu bewegen,
wobei der wasserdichte Stift dazu konfiguriert ist, wenn er eine festgelegte Position an dem zweiten Durchgangsloch erreicht, die Schubstange in einer ersten Region einer Oberfläche eines Endes des wasserdichten Stifts zu berühren und den Vorsprung in einer zweiten Region der Oberfläche des einen Endes des wasserdichten Stifts zu berühren, wobei sich die zweite Region von der ersten Region unterscheidet.

2. Elektronische Vorrichtung (101, 200, 400) nach Anspruch 1, wobei der wasserdichte Stift (403) Folgendes enthält:
ein Stiftelement, das sich entlang einer Richtung der linearen Hin- und Herbewegung innerhalb des zweiten Durchgangslochs (413b) erstreckt; und
mindestens einen ersten wasserdichten Ring, der von einer Außenumfangsoberfläche des Stiftelements vorsteht,
wobei der erste wasserdichte Ring dazu konfiguriert ist, einen Raum oder einen Abstand zwischen der Außenumfangsoberfläche des Stiftelements und einer Innenwand des zweiten Durchgangslochs abzudichten.

3. Elektronische Vorrichtung (101, 200, 400) nach Anspruch 2, wobei, wenn der wasserdichte Stift (403) die festgelegte Position an dem zweiten Durchgangsloch (413b) erreicht, der erste wasserdichte Ring sich mindestens teilweise innerhalb des zweiten Durchgangslochs befindet.

4. Elektronische Vorrichtung (101, 200, 400) nach Anspruch 1, wobei die erste Region dazu konfiguriert ist, die Schubstange (425) durch eine erste Fläche zu berühren, und die zweite Region dazu konfiguriert ist, den Vorsprung (415) durch eine zweite Fläche zu berühren, die kleiner als die erste Fläche ist.

5. Elektronische Vorrichtung (101, 200, 400) nach Anspruch 1, wobei der Vorsprung (415) Folgendes enthält:
eine Eingriffsregion, die dazu konfiguriert ist, die zweite Region des wasserdichten Stifts (403) zu berühren; und
eine Aufnahmeregion, die benachbart zu der Eingriffsregion ausgebildet ist und dazu konfiguriert ist, mindestens einen Abschnitt der Schubstange (425) unterzubringen, wenn der wasserdichte Stift die Eingriffsregion berührt.

6. Elektronische Vorrichtung (101, 200, 400) nach Anspruch 5, wobei, wenn die zweite Region des wasserdichten Stifts (403) die Eingriffsregion berührt, der mindestens eine Abschnitt der Schubstange (425) dazu konfiguriert ist, in der Aufnahmeregion untergebracht zu sein.

7. Elektronische Vorrichtung (101, 200, 400) nach Anspruch 5, wobei die Schubstange (425) dazu konfiguriert ist, sich in einer Richtung weg von dem zweiten Durchgangsloch (413b) durch den wasserdichten Stift (403) zu bewegen und anzuhalten, indem sie durch den Vorsprung (415) in der Aufnahmeregion in Eingriff genommen wird.

8. Elektronische Vorrichtung (101, 200, 400) nach Anspruch 1, ferner umfassend eine Plattenstruktur, die dazu konfiguriert ist, durch das erste Durchgangsloch (413a) lösbar an dem Gehäuse (210, 401) befestigt zu sein,
wobei die Plattenstruktur mindestens teilweise in der Buchse (423) innerhalb des Gehäuses untergebracht ist.

9. Elektronische Vorrichtung (101, 200, 400) nach Anspruch 8, wobei die Plattenstruktur Folgendes enthält:
einen Plattenkopf, der angeordnet ist, um mindestens teilweise eine durchgehende gekrümmte Oberfläche oder eine durchgehende ebene Oberfläche mit der Seitenoberfläche (210C, 410) auszubilden, während er in dem Gehäuse (210, 401) montiert ist;
einen Rahmen, der dazu konfiguriert ist, sich von einer Innenoberfläche des Plattenkopfes zu erstrecken und durch das erste Durchgangsloch (413a) in dem Gehäuse untergebracht zu sein; und
mindestens einen zweiten wasserdichten Ring, der von einer Außenumfangsoberfläche des Rahmens an einer Position benachbart zu dem Plattenkopf vorsteht,
wobei der zweite wasserdichte Ring dazu konfiguriert ist, einen Raum oder einen Abstand zwischen der Außenumfangsoberfläche des Rahmens und einer Innenwand des ersten Durchgangslochs abzudichten.

10. Elektronische Vorrichtung (101, 200, 400) nach Anspruch 8, ferner umfassend ein Schwenkelement, das schwenkbar mit der Buchse (423) gekoppelt ist,
wobei das Schwenkelement dazu konfiguriert ist, die Plattenstruktur von der Buchse durch Schwenken an der Buchse durch die Schubstange (425) zu trennen.

11. Elektronische Vorrichtung (101, 200, 400) nach Anspruch 10, wobei das Schwenkelement dazu konfiguriert ist, durch die Schubstange (425) zu schwenken, wenn sich der wasserdichte Stift (403) in einer Richtung bewegt, in der die zweite Region den Vorsprung (415) berührt.

12. Elektronische Vorrichtung (101, 200, 400) nach Anspruch 1, wobei die Schubstange (425) Folgendes enthält:
einen Verlängerungsabschnitt, der auf einer Seite der Buchse (423) angeordnet ist und sich entlang einer Richtung der linearen Hin- und Herbewegung erstreckt; und
einen gebogenen Abschnitt, der von einem Ende des Verlängerungsabschnitts gebogen ist und so angeordnet ist, dass er mindestens teilweise dem zweiten Durchgangsloch (413) zugewandt ist,
wobei der wasserdichte Stift (403) dazu konfiguriert ist, den gebogenen Abschnitt zu berühren.

13. Elektronische Vorrichtung (101, 200, 400) nach Anspruch 12, wobei bei Betrachtung entlang einer Richtung der linearen Hin- und Herbewegung des wasserdichten Stifts (403) der Verlängerungsabschnitt an einem vorbestimmten Abstand von einer Mitte des zweiten Durchgangslochs (413b) angeordnet ist und der gebogene Abschnitt angeordnet ist, um das zweite Durchgangsloch mindestens teilweise zu überlappen.

14. Elektronische Vorrichtung (101, 200, 400) nach Anspruch 12, ferner umfassend eine Vielzahl von Führungshaken, die sich von einer Seite der Buchse (423) aus erstrecken,
wobei der Verlängerungsabschnitt dazu konfiguriert ist, sich auf der einen Seite der Buchse linear hin- und herzubewegen, während er durch die Führungshaken geführt oder gestützt wird.

15. Elektronische Vorrichtung (101, 200, 400) nach Anspruch 14, wobei, wenn der wasserdichte Stift (403) die festgelegte Position an dem zweiten Durchgangsloch (413b) erreicht, ein Abschnitt des gebogenen Abschnitts dazu konfiguriert ist, durch einen der Führungshaken in Eingriff genommen zu werden.

## Revendications

1. Dispositif électronique (101, 200, 400), comprenant :
un boîtier (210, 401) comprenant un premier trou traversant (413a) formé pour pénétrer dans une surface latérale (210C, 410) et un second trou traversant (413b) disposé de manière adjacente au premier trou traversant et formé pour pénétrer dans la surface latérale ;
une saillie (415) disposée à l'intérieur du boîtier pour faire face au moins partiellement au second trou traversant ;
une douille (423) disposée à l'intérieur du boîtier et alignée avec le premier trou traversant ;
une barre de poussée (425) disposée d'un côté de la douille pour pouvoir effectuer un mouvement de va-et-vient linéaire et au moins partiellement alignée avec le second trou traversant ; et
une goupille étanche à l'eau (403) scellant le second trou traversant en étant logée dans le second trou traversant, et conçue pour déplacer la barre de poussée en effectuant un mouvement de va-et-vient linéaire au sein du second trou traversant par une force externe,
dans lequel la goupille étanche à l'eau est conçue pour, lorsqu'elle atteint une position spécifiée sur le second trou traversant, entrer en contact avec la barre de poussée dans une première région d'une surface d'une extrémité de la goupille étanche à l'eau, et entrer en contact avec la saillie dans une seconde région de la surface de la première extrémité de la goupille étanche à l'eau, la seconde région étant différente de la première région.

2. Dispositif électronique (101, 200, 400) de la revendication 1, dans lequel la goupille étanche à l'eau (403) comprend :
un élément de goupille s'étendant le long d'une direction du mouvement de va-et-vient linéaire au sein du second trou traversant (413b) ; et
au moins une première bague étanche à l'eau faisant saillie depuis une surface périphérique extérieure de l'élément de goupille,
dans lequel la première bague étanche à l'eau est conçue pour sceller un espace ou un interstice entre la surface périphérique extérieure de l'élément de goupille et une paroi intérieure du second trou traversant.

3. Dispositif électronique (101, 200, 400) de la revendication 2, dans lequel lorsque la goupille étanche à l'eau (403) atteint la position spécifiée sur le second trou traversant (413b), la première bague étanche à l'eau est au moins partiellement située au sein du second trou traversant.

4. Dispositif électronique (101, 200, 400) de la revendication 1, dans lequel la première région est conçue pour entrer en contact avec la barre de poussée (425) par une première zone, et la seconde région est conçue pour entrer en contact avec la saillie (415) par une seconde zone plus petite que la première zone.

5. Dispositif électronique (101, 200, 400) de la revendication 1, dans lequel la saillie (415) comprend :
une région d'interférence conçue pour entrer en contact avec la seconde région de la goupille étanche à l'eau (403) ; et
une région de siège formée de manière adjacente à la région d'interférence, et conçue pour loger au moins une partie de la barre de poussée (425), lorsque la goupille étanche à l'eau entre en contact avec la région d'interférence.

6. Dispositif électronique (101, 200, 400) de la revendication 5, dans lequel lorsque la seconde région de la goupille étanche à l'eau (403) entre en contact avec la région d'interférence, l'au moins une partie de la barre de poussée (425) est conçue pour être logée dans la région de siège.

7. Dispositif électronique (101, 200, 400) de la revendication 5, dans lequel la barre de poussée (425) est conçue pour se déplacer dans une direction s'éloignant du second trou traversant (413b) par la goupille étanche à l'eau (403) et s'arrêter par l'interférence de la saillie (415) dans la région de siège.

8. Dispositif électronique (101, 200, 400) de la revendication 1, comprenant en outre une structure de plateau conçue pour être fixée de manière amovible au boîtier (210, 401) à travers le premier trou traversant (413a),
dans lequel la structure de plateau est au moins partiellement logée dans la douille (423) à l'intérieur du boîtier.

9. Dispositif électronique (101, 200, 400) de la revendication 8, dans lequel la structure de plateau comprend :
un collecteur de plateau disposé pour former au moins partiellement une surface courbe continue ou une surface plate continue avec la surface latérale (210C, 410), tout en étant monté dans le boîtier (210, 401) ;
un cadre conçu pour s'étendre depuis une surface intérieure du collecteur de plateau et être logé dans le boîtier à travers le premier trou traversant (413a) ; et
au moins une seconde bague étanche à l'eau faisant saillie depuis une surface périphérique extérieure du cadre au niveau d'une position adjacente au collecteur de plateau,
dans lequel la seconde bague étanche à l'eau est conçue pour sceller un espace ou un interstice entre la surface périphérique extérieure du cadre et une paroi intérieure du premier trou traversant.

10. Dispositif électronique (101, 200, 400) de la revendication 8, comprenant en outre un élément de pivot couplé de manière pivotante à la douille (423),
dans lequel l'élément de pivot est conçu pour séparer la structure de plateau de la douille en pivotant sur la douille par la barre de poussée (425).

11. Dispositif électronique (101, 200, 400) de la revendication 10, dans lequel l'élément de pivot est conçu pour pivoter par la barre de poussée (425), lorsque la goupille étanche à l'eau (403) se déplace dans une direction où la seconde région entre en contact avec la saillie (415).

12. Dispositif électronique (101, 200, 400) de la revendication 1, dans lequel la barre de poussée (425) comprend :
une partie d'extension disposée d'un côté de la douille (423) et s'étendant le long d'une direction du mouvement de va-et-vient linéaire ; et
une partie courbée, courbée depuis une extrémité de la partie d'extension et disposée pour faire face au moins partiellement au second trou traversant (413),
dans lequel la goupille étanche à l'eau (403) est conçue pour entrer en contact avec la partie courbée.

13. Dispositif électronique (101, 200, 400) de la revendication 12, dans lequel lorsqu'il est vu le long d'une direction du mouvement de va-et-vient linéaire de la goupille étanche à l'eau (403), la partie d'extension est disposée au niveau d'un interstice prédéterminé depuis un centre du second trou traversant (413b), et la partie courbée est disposée pour chevaucher au moins partiellement le second trou traversant.

14. Dispositif électronique (101, 200, 400) de la revendication 12, comprenant en outre une pluralité de crochets de guidage s'étendant depuis un côté de la douille (423),
dans lequel la partie d'extension est conçue pour effectuer un mouvement de va-et-vient linéaire de l'un côté de la douille, tout en étant guidée ou supportée par les crochets de guidage.

15. Dispositif électronique (101, 200, 400) de la revendication 14, dans lequel lorsque la goupille étanche à l'eau (403) atteint la position spécifiée sur le second trou traversant (413b), une partie de la partie courbée est conçue pour subir l'interférence de l'un des crochets de guidage.
